# FASCICULE DE BREVET EUROPEEN

(11) **EP 3 508 369 B1**
(45) Date de publication et mention de la délivrance du brevet: **11.05.2022**
(21) Numéro de dépôt: 18213602.8
(22) Date de dépôt: 18.12.2018
(51) Int. Cl.: B60K 35/00, B60K 37/06, G05G 1/08, G06F 3/044, B60R 11/02, G02B 6/00, G05G 1/10, G06F 3/038, G06F 3/041, G08C 19/10, H01H 9/18, H01H 19/00, H01H 19/02, H03K 17/96, G06F 3/0362

(54) **INTERFACE POUR VÉHICULE AUTOMOBILE ET PROCÉDÉ DE COMMANDE**
SCHNITTSTELLE FÜR KRAFTFAHRZEUG, UND STEUERVERFAHREN
INTERFACE FOR MOTOR VEHICLE AND CONTROL METHOD

(30) Priorité: 04.01.2018 FR 1850033
(43) Date de publication de la demande: 10.07.2019
(73) Titulaire: Valeo Comfort and Driving Assistance, 94046 Créteil Cedex (FR)
(72) Inventeur: WANIR, Said, 94046 Créteil CEDEX (FR)
(74) Mandataire: Delplanque, Arnaud

(56) Documents cités:
- DE-A1-102010 010 574
- US-A1- 2003 032 490
- US-A1- 2010 090 973
- US-A1- 2017 052 617

## Description

La présente invention concerne une interface pour la commande d'au moins une fonction d'un organe de véhicule automobile. L'invention concerne également un procédé de fabrication d'une telle interface.

Dans le domaine automobile, la commande d'organes électriques, comme le système de climatisation ou de navigation, est généralement réalisée au moyen d'un bouton rotatif mécanique. Celui-ci comporte généralement une molette dont le positionnement angulaire est déterminé par exemple par un capteur optique ou par un commutateur rotatif électrique.

La position angulaire de la molette permet à une unité de traitement de sélectionner une commande particulière et de commander par exemple un actionneur de volet dans le système de climatisation ou permet à l'utilisateur d'accéder au clavier de saisie pour entrer une destination dans le système de navigation.

On connaît également, par exemple de la US2017052617 A1, un système de commande dans lequel on associe une
molette rotative à un écran tactile, en particulier un écran tactile capacitif. Par écran tactile on désigne la superposition d'un écran d'affichage et d'une dalle tactile. Par exemple, un écran tactile capacitif peut être composé en superposant (en partant de la couche la plus éloignée de l'utilisateur) un écran d'affichage TFT ou transistor en couches minces, une dalle tactile capacitive transparente et une couche protectrice transparente, par exemple du polycarbonate.

Dans ce système, une dalle tactile capacitive détecte la position angulaire d'un index métallique porté par la molette. La dalle tactile capacitive permet ainsi d'une part, la saisie tactile d'informations sur la dalle et d'autre part, de détecter la position angulaire de la molette montée rotative sur la dalle.

Dans le cas d'un écran tactile plan et capacitif, l'index métallique glisse sur la surface de l'écran selon un parcours annulaire, et sa position est suivie pour déterminer la position de rotation et le mouvement de la molette.

La rotation de la molette permet notamment à l'utilisateur de faire défiler un élément dans une liste ou d'incrémenter/décrémenter une variable, la sélection ainsi opérée pouvant être affichée sur l'écran. Une fois l'élément sélectionné ou la valeur de la variable modifiée, le choix peut ensuite être validé par contact de l'écran tactile ou une pression sur la molette si l'interface est pourvue de capteurs d'appui.

Dans le cadre d'une intégration dans l'intérieur de l'habitacle, les constructeurs automobiles peuvent privilégier des écrans tactiles à surface courbe, épousant une forme courbe de la planche de bord par exemple. Ainsi, l'écran tactile peut être intégré de façon plaisante esthétiquement, notamment de sorte à être peu visible à l'état éteint.

Dès lors, il est a priori impossible d'utiliser une molette à index capacitif sur un écran ou une surface tactile courbé.

Un des buts de la présente invention est donc de proposer une interface améliorée qui résolve au moins en partie ces inconvénients et de permettre d'utiliser une molette à index capacitif en combinaison avec une interface à surface tactile courbe.

A cet effet, l'invention a pour objet une interface, en particulier pour habitacle de véhicule automobile, pour la commande d'au moins une fonction d'un organe de véhicule automobile, comportant entre autres :
- au moins un organe de commande comprenant :
   ∘ un élément mobile de préhension,
   ∘ au moins un index métallique porté par l'élément mobile de préhension et mobile avec celui-ci,
   ∘ un guide, l'élément mobile de préhension étant supporté et guidé en déplacement par le guide, et
- une dalle tactile capacitive configurée pour détecter la position de l'index métallique , l'index métallique étant agencé en regard de la dalle tactile capacitive, présentant une surface extérieure courbe selon au moins une direction,

l'espace entre l'élément de commande et la surface extérieure courbe de la dalle tactile capacitive étant rempli par une couche de colle interstitielle.

L'utilisation d'une couche de colle interstitielle, en particulier de colle initialement liquide permet d'éviter la présence d'une lame d'air qui fausse la lecture de position de l'index capacitif de l'interface. Le fait d'utiliser une colle initialement liquide permet aussi de s'affranchir de l'usinage séparé d'une pièce en plastique ou résine de forme adaptée, les tolérances d'usinages combinées de la dalle tactile capacitive et de ladite pièce rendant difficile d'assurer l'absence totale de lame d'air entre l'index et ladite dalle tactile

L'interface peut alors présenter une ou plusieurs des caractéristiques suivantes, prises seules ou en combinaison.

L'organe de commande est une molette rotative, l'élément mobile de préhension étant une molette circulaire, et le guide comportant un roulement guidant l'élément mobile de préhension en rotation.

Elle comporte un écran d'affichage configuré pour afficher des informations associées à un contact, un déplacement ou un appui de la partie mobile de préhension ou à un contact ou un appui sur la dalle tactile capacitive.

L'écran d'affichage est fixé à la dalle tactile capacitive, la dalle tactile capacitive étant au moins partiellement transparente.

L'organe de commande comporte au moins un guide de lumière présentant un dioptre d'entrée situé en vis-à-vis de l'écran d'affichage et un dioptre de sortie situé en direction de l'habitacle du véhicule automobile, et la colle utilisée pour réaliser la couche de colle interstitielle est au moins partiellement transparente dans au moins une portion du spectre visible pour guider de la lumière de l'écran d'affichage vers l'habitacle du véhicule.

Le guide de lumière comporte une partie centrale cylindrique dont une surface frontale forme un dioptre de sortie, et, à son extrémité inférieure, une portion plane, s'étendant radialement vers l'extérieur de l'organe de commande, formant ainsi un socle, et dont la portion radialement extérieure forme un espaceur annulaire, sur lequel le guide de l'élément de préhension mobile prend appui.

Elle comporte au moins un capteur d'appui agencé à l'arrière de l'écran d'affichage.

L'index métallique est relié à une surface extérieure métallique de l'élément de préhension mobile par un organe élastique métallique configuré pour pousser l'index métallique selon une direction sensiblement normale à la surface extérieure de la dalle tactile capacitive vers l'intérieur de l'interface.

L'invention se rapporte aussi au procédé associé de fabrication d'interface pour véhicule automobile, l'interface comportant entre autres :
∘ au moins un organe de commande comprenant :
   ▪ un élément mobile de préhension,
   ▪ au moins un index métallique porté par l'élément mobile de préhension et mobile avec celui-ci,
   ▪ un guide, l'élément mobile de préhension étant supporté et guidé en déplacement par le guide, et
∘ une dalle tactile capacitive configurée pour détecter la position de l'index métallique, l'index métallique étant agencé en regard de la dalle tactile capacitive, présentant une surface extérieure courbe selon au moins une direction,
le procédé comportant les étapes suivantes :
   - dépôt d'une couche de colle interstitielle réticulable et initialement liquide dans l'espace entre l'élément de commande et la surface extérieure courbe de la dalle tactile capacitive,
   - fixation de l'organe de commande sur ou au moyen de ladite couche de colle interstitielle.

Le procédé peut alors présenter une ou plusieurs des caractéristiques suivantes, prises seules ou en combinaison.

Il comporte une étape préalable de disposition d'un élément annulaire au niveau de la position finale de l'organe de commande, dont le bord inférieur est ajusté à la courbure de la plaque frontale, et l'on injecte de colle liquide pour former la couche de colle interstitielle dans l'espace délimité par ledit élément annulaire, la surface extérieure de la dalle tactile capacitive, et l'organe de commande.

L'élément annulaire forme, après réticulation de la colle formant la couche de colle interstitielle, une jupe inférieure de l'organe de commande.

L'organe de commande comporte sur sa surface inférieure des plongeurs qui plongent dans la couche de colle interstitielle, et est disposé sur la dalle tactile capacitive avant une étape de réticulation de la colle de la couche de colle interstitielle.

L'organe de commande comporte une surface inférieure plane, et l'étape de fixation de l'organe de commande sur la couche de colle interstitielle est effectuée sur la couche de colle interstitielle réticulée par application d'une couche mince de colle.

La colle liquide est une colle réticulée par irradiation électromagnétique et en ce le procédé comporte une étape d'irradiation électromagnétique de la colle liquide formant la couche de colle interstitielle.

D'autres caractéristiques et avantages de l'invention ressortiront de la description suivante, donnée à titre d'exemple et sans caractère limitatif, en regard des dessins annexés sur lesquels :
- la figure 1 représente une vue d'une portion de l'habitacle intérieur d'un véhicule automobile comprenant une interface qui est installée à titre d'exemple au niveau du panneau avant du véhicule,
- la figure 2 montre une vue de face de l'interface de la figure 1,
- la figure 3 montre une vue éclatée d'un exemple d'organe de commande pour l'interface de la figure 2,
- la figure 4 est une vue en coupe d'une interface selon un mode de réalisation particulier,
- la figure 5 est un organigramme de procédé de fabrication d'une interface selon l'invention,
- les figures 6 à 11 illustrent des étapes d'un procédé de fabrication d'une interface selon l'invention,
- la figure 12 est un organigramme de procédé alternatif de fabrication d'une interface selon l'invention.

Sur ces figures, les éléments identiques portent les mêmes numéros de référence.

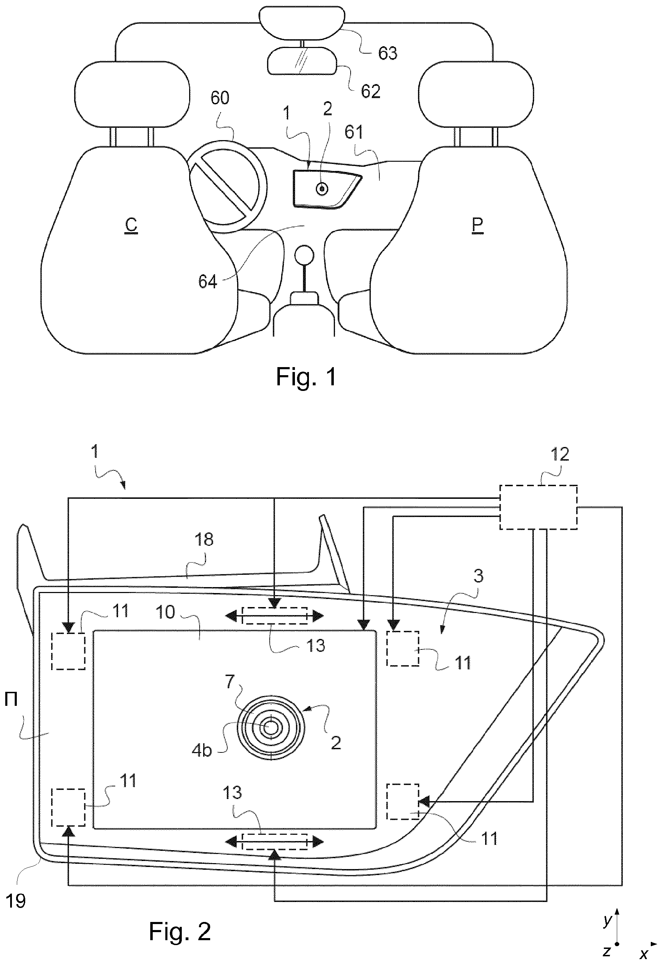

Pour la discussion qui suit, afin de fournir une orientation et une indexation des couches composant l'interface, la surface apparente de ladite interface est désignée comme étant « extérieure » et/ou « supérieure. » On peut en effet orienter l'interface et en particulier la dalle tactile qu'elle comporte de sorte à être sensiblement horizontales dans un plan *xy,* avec les couches invisibles pour l'utilisateur orienté vers le bas selon un axe z défini vertical bien que sa disposition finale puisse être différente (voir figure 1).

Les termes tels que « intérieur » « extérieur » « au-dessus » « au-dessous » et équivalents sont donnés, en l'absence de précision autre, en respectant cette orientation.

La figure 1 montre des éléments d'une partie avant d'habitacle de véhicule automobile.

L'habitacle comprend notamment un siège conducteur noté C disposé derrière un volant 60 et un panneau avant 61 (aussi appelé planche de bord), un siège passager noté P, un rétroviseur intérieur 62, un module de plafonnier 63 aussi appelé dôme placé à proximité du rétroviseur intérieur 62 dans la partie centrale haute de la partie avant de l'habitacle et une console centrale 64 située entre les deux sièges C, P de la partie avant de l'habitacle.

L'habitacle comporte une interface 1 notamment propre à être logée dans le panneau avant 61 du véhicule. Bien entendu, l'interface 1 peut également être disposée à d'autres endroits de l'habitacle comme par exemple au niveau de la console centrale 64 ou tout autre endroit adapté.

Une telle interface 1 permet la commande d'au moins une fonction d'un organe de véhicule automobile telle que la commande des fonctions d'un système de climatisation, d'un système audio, d'un système de téléphonie ou encore d'un système de navigation. Cette interface 1 peut également servir pour les commandes de lève-vitres, de positionnement des rétroviseurs extérieurs ou encore pour le déplacement de sièges motorisés ou pour commander des lumières intérieures, un verrouillage central, un toit ouvrant, les feux de détresse ou les lumières d'ambiance.

L'interface 1 permet par exemple à l'utilisateur une sélection par défilement dans une liste ou une modification d'une valeur de paramètre ou une validation d'une sélection. Elle permet par exemple à l'utilisateur de sélectionner une adresse postale de destination ou un nom dans un répertoire, les réglages du système de climatisation ou la sélection d'une piste musicale dans une liste.

L'interface 1 comporte au moins un organe de commande 2, une dalle tactile capacitive 3 et au moins un capteur d'appui 11.

La figure 2 montre une vue plus détaillée de l'interface 1 en vue de face, dans le plan *xy* contenant au moins partiellement la surface affichant la liste et les menus, ou tangent à celle-ci.

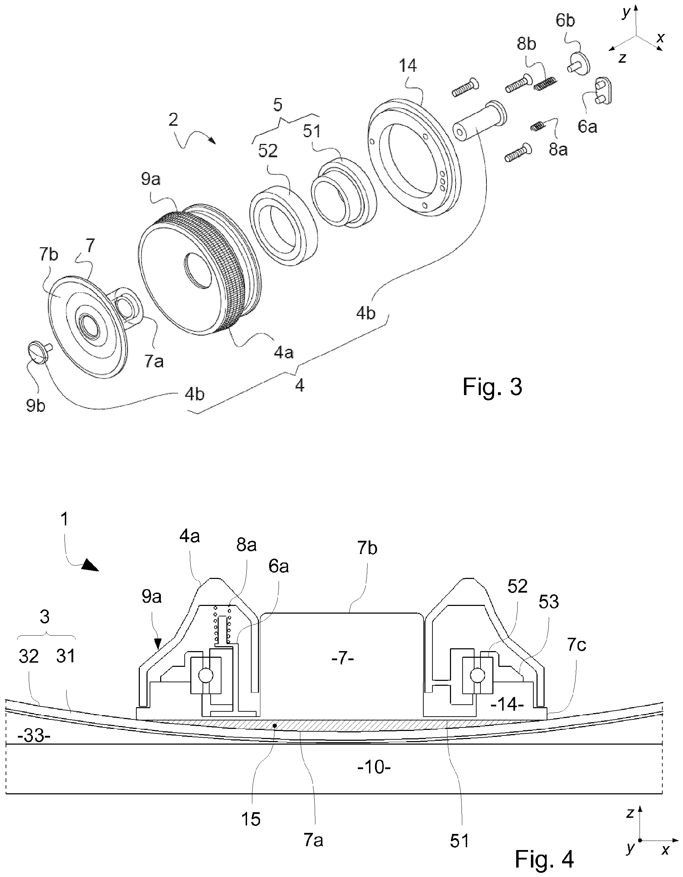

La dalle tactile capacitive 3 comprend au moins (voir figure 4) un capteur capacitif 31 et une plaque frontale 32 agencée sur le capteur capacitif 31. Le capteur capacitif 31 est fixé à la plaque frontale 32 par exemple par une couche de colle de remplissage 33 dite colle optique.

Le capteur capacitif 31 permet de détecter une variation de capacité au niveau de la surface de la plaque frontale 32. Le capteur capacitif 31 peut par exemple détecter un contact d'un doigt d'un utilisateur. Le capteur capacitif 31 permet également de déterminer les coordonnées spatiales du doigt sur la surface de la dalle 3. Le capteur capacitif 31 est par exemple formé d'un réseau d'électrodes s'étendant sur tout ou partie de la surface arrière de la plaque frontale 32. Les électrodes sont par exemple réalisées en ITO (oxyde indium - étain) qui permettent au capteur 31 d'être transparent.

La rigidité de la dalle tactile capacitive 3 est obtenue au moyen de la plaque frontale 32 (ou plaque de contact) rigide, telle qu'une plaque de verre ou de plastique courbée dans au moins une direction. La surface extérieure de la plaque frontale 32, orientée vers l'habitacle du véhicule, est ici courbée concave (voir figure 4).

D'autres modes de réalisation peuvent comporter une surface extérieure courbée convexe, et des surfaces à doubles courbure, de forme bombée ou en cuvette. Des modes de réalisation plus complexes peuvent même incorporer des courbures variables plus complexes (p. ex. en « vaguelette ») dans la limite d'un dénivelé inférieur à une certaine hauteur maximale de l'ordre de quelques millimètres, typiquement 5 à 8mm selon la taille de l'organe de commande 2.

La plaque frontale 32 agencée sur le capteur capacitif 31 fait face à l'utilisateur une fois montée dans l'habitacle. La surface tactile de la dalle 3 est ainsi formée par la surface extérieure de la plaque frontale 32 courbée ici selon une direction .

La plaque frontale 32 peut être au moins partiellement transparente et/ou au moins partiellement opaque de manière à cacher les éléments disposés derrière.

La plaque frontale 32 peut être entièrement opaque, la dalle tactile capacitive 3 formant un pavé tactile ou « Touchpad » en anglais. Une telle interface 1 ayant un organe de commande 2 collé sur la dalle tactile capacitive 3 est compacte. En effet, une telle interface 1 regroupe deux éléments manipulables par l'utilisateur dans un même emplacement de l'habitacle sans nécessiter d'emplacement dédié pour la fixation de l'organe de commande 2. Cela permet aussi d'avoir une interface 1 reconfigurable. La saisie de caractères est fastidieuse avec une molette, voire impossible pour les caractères asiatiques. L'organe de commande 2 collé sur une dalle 3 permet d'obtenir dans un espace réduit une interface 1 multifonctions capable de réaliser une reconnaissance aisée des caractères grâce à la dalle, associée au confort de préhension d'un organe de commande 2.

Selon d'autres modes de réalisation, l'organe de commande 2 peut aussi ou en alternative comporter une ou plusieurs glissières mobiles en translation, ou bien des touches enfonçables.

Un écran d'affichage 10, tel qu'un écran TFT (« Thin-Film Transistor » en anglais) ou un écran LED ou un écran LCD peut être configuré pour afficher des informations associées à la manipulation de l'interface 1.

Selon un premier exemple de réalisation représenté sur la figure 2, l'interface 1 comporte au moins deux capteurs d'appui 11, par exemple quatre, agencés de part et d'autre de l'écran d'affichage 10. Les capteurs d'appui 11 sont configurés pour mesurer un déplacement d'un support 19 mobile, portant la dalle tactile 3 et l'écran d'affichage 10, par rapport à une partie fixe 18 rattachée par exemple à un cadre solide de la console centrale 64 du véhicule.

Le support 19 est par exemple métallique ou présente un revêtement métallique en face arrière, au moins en face de l'électrode du capteur d'appui 11 porté par une carte électronique. Ces surfaces métalliques peuvent être détectées par l'électrode du capteur d'appui 11. Les capteurs d'appui 11 sont ainsi agencés en regard du support 19, lui-même fixé à une portion périphérique Π de la plaque frontale 32 qui est opaque (figure 2), ils ne sont donc pas visibles par l'utilisateur.

Les capteurs d'appui 11 sont disposés à l'emplacement où le déplacement de la partie mobile 16 est le plus important.

En fonctionnement, lorsque l'utilisateur appuie sur la plaque frontale 32 ou sur l'organe de commande 2, le capteur d'appui 11 détecte le déplacement de la dalle tactile capacitive 3 vers la partie fixe 18, représentatif d'une force d'appui.

La mesure de la force d'appui peut aussi être réalisée par d'autres moyens comme par mesure inductive ou par mesure ultrason ou par mesure de déformation au moyen de jauges de contrainte ou de capteurs FSR (pour « Force Sensing Resistor » en anglais). En alternative, les capteurs d'appui peuvent être, par exemple, des cristaux piézoélectriques ou bien des capteurs dits « cloquants » qui fournissent, en plus d'un signal à l'enfoncement, un retour haptique simple pour signifier un appui à l'utilisateur.

Une unité de traitement 12 peut être reliée aux capteurs d'appui 11 et au capteur capacitif 31 (figure 2). L'unité de traitement 12 comporte un ou plusieurs microcontrôleurs ou ordinateurs, ayant des mémoires et programmes adaptés pour modifier l'affichage de l'écran 10, pour recevoir les informations de position détectées par la dalle tactile capacitive 3 et pour recevoir les signaux de mesure des capteurs 11. C'est par exemple l'ordinateur de bord du véhicule automobile. L'unité de traitement 12 peut être configurée pour évaluer une force d'appui à partir des capteurs d'appui 11 notamment en additionnant les forces mesurées par chaque capteur 11.

Un exemple d'organe de commande 2 est également visible sur la vue éclatée de la figure 3.

On voit sur ces figures que l'organe de commande 2 comporte un élément mobile de préhension 4, au moins un index métallique 6a, 6b porté par l'élément mobile de préhension 4 et mobile avec celui-ci, et un guide 5. L'élément mobile de préhension 4 est supporté et guidé en déplacement par le guide 5.

Le guide 5 est fixé sur la plaque frontale 32 de la dalle tactile capacitive 3 (voir figure 4), par exemple par collage. Le guide 5 est par exemple fixé au centre de la dalle tactile capacitive 3 (figures 1 et 2) ou dans un coin ou côté de la dalle tactile capacitive 3.

L'organe de commande 2 est ici un bouton rotatif, l'élément mobile de préhension 4 étant alors mobile en rotation autour d'un axe de rotation selon une normale à au moins une portion de la surface extérieure de la dalle tactile capacitive 3, ou bien à une moyenne de ladite surface extérieure recouverte par l'organe de commande 2.

L'élément mobile de préhension 4 rotatif est supporté et guidé en rotation par le guide 5 qui comporte ici un palier rotatif. L'élément mobile de préhension 4 et le guide 5 présentent alors avantageusement des formes générales cylindriques coaxiales.

Selon un exemple de réalisation, le guide 5 comporte un socle 51 fixé à la dalle tactile capacitive 3 et un roulement mécanique 52, tel qu'un roulement à billes ou un roulement à cylindres ou un roulement à aiguilles, monté sur le socle 51, le roulement mécanique 52 étant interposé entre le socle 51 et l'élément mobile de préhension 4.

Le roulement mécanique 52 permet de limiter les frottements et d'assurer un bon guidage en rotation de l'élément mobile de préhension 4. La réduction des frottements permet une bonne longévité de l'organe de commande 2 et limite les bruits. Le bon guidage en rotation produit un ressenti de qualité à l'utilisateur, lui permettant une navigation fluide et aisée dans les différents menus.

Le bon guidage en rotation permet aussi d'éviter à l'élément mobile de préhension 4 de se positionner de travers lors de la rotation, ce qui pourrait coincer les index métalliques 6a, 6b.

En outre, le roulement mécanique 52 permet de transmettre un effort exercé sur l'organe de commande 2 vers la dalle tactile capacitive 3 pour que celui-ci puisse être détecté par les capteurs d'appui 11. Également, la possibilité de transmettre un effort entre l'organe de commande 2 et la dalle 3 permet qu'un retour haptique généré sur la dalle 3 puisse être transmis aux doigts de l'utilisateur par l'organe de commande 2. En effet, le roulement mécanique 52 permet de former une liaison rigide entre l'élément mobile de préhension 4 et le socle 51 collé à la dalle tactile capacitive 3.

Le roulement mécanique 52 peut comporter un joint d'étanchéité permettant notamment d'améliorer la manœuvrabilité de l'organe de commande 2.

D'autres moyens de guidage en rotation du guide 5 sont envisageables, tels que des paliers lisses, comme des coussinets ou bagues autolubrifiantes ou tels que des billes élastiquement sollicitées à l'encontre de l'élément mobile de préhension 4.

Dans le cadre d'un mode de réalisation à boutons glissières mobiles en translation, le guide 5 pourra comporter un ou plusieurs rails, dans lesquels les boutons glissières sont limités à une translation selon un axe prédéterminé.

L'organe de commande 2 de la figure 3 comporte aussi un espaceur 14 annulaire et fixe en rotation, qui transmet la pression de l'utilisateur de l'élément mobile de préhension 4 à la dalle tactile 3

Le guide 5 peut aussi comporter des moyens de génération d'un retour haptique, par exemple des aimants en vis-à-vis, en partie fixe et en partie entraînés en rotation ; ou bien des cliquets mécaniques, afin de générer un couple résistif variable perçu sous forme de crans permettant à l'utilisateur de quantifier son mouvement de rotation sans vérification visuelle.

L'extrémité de l'élément mobile de préhension 4 en regard de la dalle tactile capacitive 3 porte au moins un index métallique 6a, 6b qui est ainsi agencé en vis-à-vis de la dalle tactile capacitive 3. Il s'agit par exemple d'une languette métallique, par exemple en cuivre.

L'index métallique 6a, 6b est électriquement connecté à une surface métallique externe 9a, 9b de l'élément mobile de préhension 4 destinée à être manipulée par l'utilisateur. La surface métallique externe 9a, 9b recouvre au moins en partie la surface externe de l'élément mobile de préhension 4.

Pour cela, l'élément mobile de préhension 4 est par exemple au moins en partie réalisé en matériau métallique.

Selon un autre exemple, l'élément mobile de préhension 4 comporte un revêtement agencé au niveau de la surface externe de préhension, tel qu'une enveloppe chromée connectée à l'index métallique 6a, 6b.

En touchant la surface métallique externe 9a, 9b électriquement connectée à l'index métallique 6a, 6b, l'utilisateur amène des charges électriques en regard de la dalle tactile capacitive 3 qui sont alors détectées par le capteur capacitif 31. La détection de ces charges dans la zone de l'organe de commande 2 permet d'en déduire le contact de l'organe de commande 2 par l'utilisateur. La détermination des coordonnées de l'index métallique 6b par la dalle tactile capacitive 3 permet également de déterminer la position angulaire de l'index métallique 6b mobile au-dessus de la dalle tactile capacitive 3.

L'élément mobile de préhension 4 comporte donc deux parties, une fixe 4a, et une mobile 4a. La partie mobile 4a est ici une molette circulaire portant une surface externe métallisée 9a, en particulier sur sa jupe tubulaire extérieure.

La partie fixe 4b comporte notamment un tube central et une vis frontale 9b, le tube central présentant un taraudage dans lequel la vis frontale 9b est insérée à travers un trou central de la molette circulaire pour la fixer en translation tout en permettant sa rotation. Le tube central présente une embase qui peut être collée sur la surface extérieure de la dalle tactile 3.

On commande par exemple une fonction de l'interface 1, telle qu'une validation d'une sélection, lorsqu'une force d'appui exercée sur la dalle tactile capacitive 3 est supérieure à un seuil d'appui, par exemple lorsque la force d'appui est supérieure à 3N.

La fonction de l'interface 1 peut être commandée relativement à l'intensité de la force d'appui exercée sur la dalle tactile capacitive 3. Par exemple, la fonction est un agrandissement de l'image affichée sur l'écran 10 et l'agrandissement est proportionnel à l'intensité de la force d'appui exercée sur la dalle 3.

On peut en outre commander au moins une fonction de l'interface 1 lorsque la dalle tactile capacitive 3 détecte un contact de l'organe de commande 2 et lorsqu'une force d'appui supérieure à un seuil d'appui est exercée sur la dalle tactile capacitive 3.

La mesure d'une force d'appui supérieure au seuil d'appui peut permettre de confirmer la détection d'un contact de l'organe de commande 2 par la dalle tactile capacitive 3 du fait de la redondance de l'information.

La détection d'un contact de l'élément mobile de préhension 4 et la mesure d'un appui sur l'organe de commande 2 supérieure à un seuil d'appui peuvent notamment permettre la validation d'une fonction, telle qu'une fonction du système de climatisation, de navigation, de l'autoradio ou la validation d'une sélection d'un choix parmi une liste, telle qu'une liste téléphonique. Il est notamment ainsi possible d'exécuter une fonction, comme une validation d'une sélection, par simple appui sur l'organe de commande 2.

L'interface 1 peut aussi comporter au moins un actionneur vibratoire 13 configuré pour faire vibrer au moins la dalle tactile capacitive 3 en réponse à un contact, un déplacement ou un appui de l'élément mobile de préhension 4 ou à un contact ou un appui exercé sur la dalle tactile capacitive 3. L'interface 1 comporte par exemple deux actionneurs vibratoires 13 par exemple fixés au support 19 de la plaque frontale 13 de la dalle tactile capacitive 3 (voir figure 2).

Les actionneurs vibratoires 13 peuvent être agencés de part et d'autre de l'écran 10, tel qu'à droite et à gauche ou tel qu'en haut et en bas de l'écran 10 en référence à la position verticale de l'interface 1 montée dans le véhicule (figure 1).

Les actionneurs vibratoires 13 peuvent être montés de manière à diriger la vibration dans le plan de l'écran 10 ou orthogonalement au plan de l'écran 10, ou selon une combinaison de ces directions pour obtenir en particulier des profils de retour haptique différents.

La possibilité de faire vibrer la dalle 3 permet de faire vibrer l'organe de commande 2 fixé sur la dalle 3. En effet, le retour haptique ne se fait pas uniquement sur la dalle tactile capacitive 3 mais il est également transmis à la main de l'utilisateur à travers l'organe de commande 2 fixé sur la dalle 3. Cela est possible du fait de la bonne transmission des forces entre l'organe de commande 2 et l'actionneur 13 qui est obtenue notamment par fixation du guide 5 par collage sur la dalle 3 et par l'emploi d'un roulement mécanique 52 ne permettant pas de libre translation axiale.

Ce retour haptique peut par exemple permettre d'indexer les positions angulaires de l'élément mobile de préhension 4 en alternative à des moyens de génération de retour haptique dédiés.

L'organe de commande 2 comporte aussi au moins un organe élastique métallique 8a, 8b, ici un ressort hélicoïdal de compression, en particulier au moins un par index métallique 6a, 6b.

Une première extrémité de l'organe élastique métallique 8a, 8b est connectée à une surface métallique externe 9a de l'élément mobile de préhension 4 et une deuxième extrémité est fixée à l'index métallique 6a, 6b.

L'organe élastique métallique 8a, 8b est configuré pour pousser l'index métallique 6a, 6b selon une direction sensiblement normale à la surface extérieure de la dalle capacitive 3 vers l'intérieur de l'interface 1.

La pression exercée sur l'index métallique 6a, 6b assure d'un contact entre l'index métallique 6a, 6b et la dalle 3. L'index métallique 6a, 6b peut ainsi être perçu par la dalle 3, indépendamment de tolérances de fabrication. En outre, l'organe élastique métallique 8a, 8b est conducteur, ce qui permet d'assurer le transfert de charge entre l'index métallique 6a, 6b et la surface métallique externe 9a de l'élément mobile de préhension 4.

L'index métallique 6a, 6b, l'organe élastique métallique 8a, 8b et la surface métallique externe 9a sont électriquement liés et isolés de la carcasse métallique du véhicule formant la masse, et forment ainsi une électrode de dispositif capacitif avec laquelle l'utilisateur entre en contact pour interagir avec l'interface 1.

L'organe de commande 2 comporte aussi un guide de lumière 7, présentant un dioptre d'entrée 7a situé, à l'état assemblé en vis-à-vis de l'écran d'affichage 10 et un dioptre de sortie 7b situé en direction de l'habitacle du véhicule automobile. Le guide de lumière 7 est transparent au moins dans une portion du spectre visible, et en particulier au moins dans les canaux RGB (rouge-vert-bleu) associés à l'écran d'affichage 10.

Le guide de lumière guide ainsi une partie de la lumière de l'écran d'affichage 10 vers l'habitacle du véhicule lorsque l'écran d'affichage 10 est allumé, en particulier la lumière émise par la portion d'écran d'affichage 10 recouverte par l'organe de commande 2. Le guide de lumière 7 peut alors en particulier être réalisé en polycarbonate transparent « blanc » à transparence élevée sur la presque totalité du spectre visible pour permettre un rétroéclairage de couleur variable, la lumière étant fournie par la portion d'écran d'affichage située sous l'organe de commande 2 qui peut afficher un nombre élevé de couleurs.

Le guide de lumière 7 est ici conique sur sa portion supérieure, avec un dioptre de sortie 7b annulaire aidant à l'identification des contours de l'élément mobile de préhension 4 par exemple lors de la circulation de nuit. La portion inférieure du guide de lumière 7 est tubulaire et coaxiale avec l'élément mobile de préhension 4 pour permettre la rotation de celui-ci.

Une interface 1 est montrée en coupe axiale selon le plan xz en figure 4, avec l'organe de commande 2 positionné sur la dalle tactile 3.

La dalle tactile 3 comporte ici un écran TFT 10, surmonté d'un détecteur capacitif 31, et d'une plaque frontale 32. L'écran TFT 10 est plan, tandis que le détecteur capacitif 31 ainsi que la plaque frontale 32 sont courbés concaves pour l'utilisateur de l'interface 1, et de courbure sensiblement identique.

Le détecteur capacitif 31 et la plaque frontale 32 sont tangents à l'écran TFT 10 au niveau du centre de celui-ci, et s'en écartent vers le haut en direction des bords de l'interface 1. Une couche de colle de remplissage 33 est injectée dans l'espace ainsi délimité. Cette couche de colle de remplissage 33 est en particulier transparente, et d'indice sensiblement égal à celui de la plaque frontale 32 et du détecteur capacitif 31 (eux-mêmes transparents pour permettre la visualisation des images affichées à l'écran TFT 10). Cette technique de remplissage est connue sous le nom anglais de « optical bonding » ou « collage optique » en français.

La plaque frontale 32 est surmontée d'une couche de colle interstitielle 15, par exemple de la même composition chimique que la colle de remplissage 33, ou au moins ayant une composition qui lui assure des propriétés, en particulier optiques, sensiblement identiques à celles de la colle de remplissage 33.

La colle de la couche de colle interstitielle 15 est en particulier isolante électrique, initialement liquide et durcit une fois réticulée. La couche de colle interstitielle 15 épouse donc d'un côté la courbure de la surface de la plaque frontale 32, et présente de l'autre côté une surface plane, de sorte à remplir ou combler l'espace entre la surface courbe de la dalle tactile 3 et l'organe de commande 2, qui présente ici une surface inférieure relativement plane complémentaire.

L'organe de commande 2 est ici un bouton rotatif, pourvu d'un élément mobile de préhension 4 réalisé sous forme de molette, qui comporte en son centre un guide de lumière 7 de forme cylindrique, qui transmet de la lumière émise par l'écran TFT 10 à l'habitacle via un dioptre de sortie 7b circulaire qui forme une portion centrale rétroéclairée de la surface supérieure apparente de l'organe de commande 2 .

L'élément mobile de préhension 4 est ici annulaire, avec une partie mobile 4a recouverte d'une couche métallique formant la couche métallique externe 9a sur toute sa surface, et guidée en rotation par un roulement à billes 52.

Le guide de lumière 7 comporte à son extrémité inférieure une portion plane, s'étendant radialement vers l'extérieur de l'organe de commande 2, formant ainsi un socle 51, et dont la portion radialement extérieure forme un espaceur 14 annulaire, sur lequel l'anneau fixe du roulement à billes 52 prend appui, par coopération de forme, compression ou collage, ici par addition d'un anneau de fixation 53 qui est collé ou vissé à l'espaceur en enserrant l'anneau fixe en rotation du roulement à bille. Le guide de lumière central 7, le socle 51 et l'espaceur 14 viennent ainsi de matière, et peuvent être obtenus lors d'une unique étape de moulage par injection de plastique transparent ou translucide, notamment du polycarbonate.

Cette pièce unique 7, 51, 14 comporte une surface inférieure plane
complémentaire de la surface plane de la couche de colle interstitielle 15. L'organe de commande 2 forme alors, une fois assemblé, un module d'une seule pièce qui est aisément positionné et collé sur la couche de colle interstitielle 15 durcie.

En utilisant une colle initialement liquide pour la couche de colle interstitielle 15, on est aussi assuré qu'aucune lame d'air résiduelle ne persiste entre l'index métallique 6a et le détecteur capacitif 31.

Une portion de la jupe extérieure de l'espaceur 14 est ici apparente sous la partie mobile 4a de l'élément mobile de préhension 4, et forme un dioptre annulaire 7c, qui permet notamment de rendre l'organe de commande 2 visible par rétroéclairage lorsque l'écran TFT 10 est éteint ou noir sur toute sa surface sauf une portion située sous l'organe de commande 2, fournissant ainsi la source de lumière du rétroéclairage.

La partie mobile 4a de l'élément mobile de préhension 4 est creuse, avec une section en forme de cloche ou de U retourné, de sorte à délimiter avec le socle 51 un espace annulaire, dans lequel est logé l'index métallique 6a. L'index métallique 6a est plaqué contre le socle 51 par un ressort métallique 8a de compression, qui forme aussi un contact électrique avec la couche métallique externe 9a. L'index métallique 6a évolue alors entre l'espaceur 14 de forme annulaire et le guide de lumière central 7.

On remarque à nouveau que l'index métallique 6a, le ressort métallique 8a et la couche métallique externe 9a forment une électrode conductrice isolée de la carcasse du véhicule formant masse du circuit, et avec laquelle l'utilisateur entre en contact pour interagir avec l'interface 1.

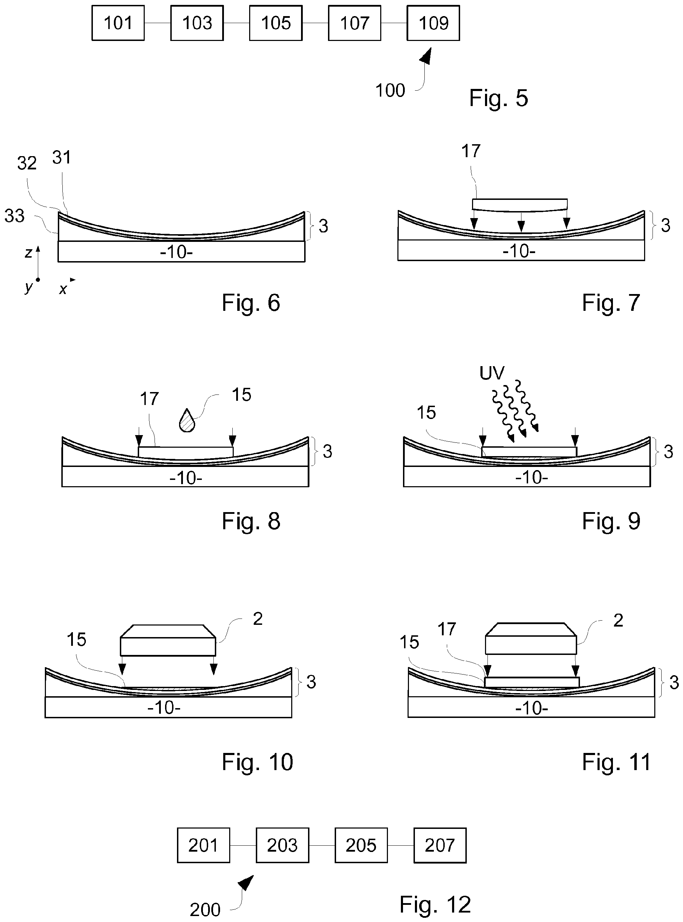

La figure 5 est un organigramme linéaire reprenant les principales étapes d'un procédé 100 de fabrication d'une interface 1 selon l'invention. Les figures 6 à 11 illustrent certaines de ces étapes.

Le point de départ du procédé 100, illustré en figure 6, est la dalle tactile 3, de surface extérieure courbée placée vers le haut par rapport à la gravité locale. La courbure est ici une courbure simple dans le plan de l'image.

La dalle tactile 3 comporte ici aussi en particulier un écran d'affichage 10 plan, sur lequel est disposé un détecteur capacitif 31 surmonté d'une plaque frontale 32, tous deux courbés à un même rayon de courbure. Une couche de colle de remplissage 33 remplissant l'espace entre l'écran d'affichage 10 et le détecteur capacitif 31.

La première étape 101 du procédé 100, illustrée en figure 7, est la disposition d'un élément annulaire 17, dont le bord inférieur est ajusté à la courbure de la plaque frontale 32 au niveau de la position finale de l'organe de commande 2. L'élément annulaire 17 peut en particulier comporter une lèvre déformable (p. ex. une bande fine de caoutchouc) sur son pourtour inférieur appuyé sur la dalle tactile 3, de sorte à assurer une certaine étanchéité.

La seconde étape 103 du procédé 100, illustrée en figure 8, est l'injection de colle 15 liquide dans l'espace délimité par l'élément annulaire 17 et la surface de la dalle tactile 3 sous ledit élément annulaire 17. Pendant cette étape une pression sur l'élément annulaire est maintenue pour éviter une fuite de la colle 15 liquide. Cette pression est illustrée par des flèches verticales en figure 8. Du fait de son état liquide, la colle 15 épouse la forme courbée de la plaque frontale 32 tout en présentant une surface supérieure plane simplement du fait de la gravité.

En orientant l'écran d'affichage 10 dans le champ de gravité local, on peut contrôler l'orientation de la surface supérieure de la couche de colle interstitielle 15 obtenue après réticulation de la colle 15 liquide.

La troisième étape 105 du procédé 100, illustrée en figure 9, est la réticulation de la colle 15 initialement liquide. La réticulation est ici initiée par une irradiation par rayonnement ultra-violet UV, par exemple par un flash de courte durée et de forte intensité. Durant le durcissement de la colle 15 la pression sur l'élément annulaire est maintenue.

Si la colle 15 utilisée est une colle bicomposants, cette étape est simplement une étape d'attente d'un durcissement suffisant, accélérée éventuellement par soufflage d'air chaud.

La quatrième étape 107 de ce mode de réalisation particulier du procédé 100, qui n'est pas représentée sur les figures, est le retrait de l'élément annulaire 17. Pour permettre son retrait après réticulation, sa surface interne peut être couverte de matériaux avec lesquels la colle 15 utilisée n'adhère pas ou peu.

On obtient alors la couche de colle interstitielle 15 dure à surface supérieure plane (figure 10).

La cinquième étape 109 du procédé 100, illustrée en figure 10, est la fixation de l'organe de commande 2 sur la surface plane supérieure de la couche de colle interstitielle 15, par exemple au moyen d'une fine couche de colle supplémentaire.

La figure 11 illustre un mode de réalisation alternatif de procédé 100 dans lequel l'élément annulaire 17 est incorporé dans l'interface 1 finale en formant une jupe extérieure de l'organe de commande 2. L'élément annulaire 17 comporte alors typiquement un chanfrein annulaire ou cylindrique sur son bord supérieur pour accueillir et centrer l'organe de commande 2.

L'organe de commande 2 peut être positionné avant réticulation de la colle, et comporter des plongeurs (picots, anneaux, languettes etc.) au moins partiellement axiaux (axe z) qui plongent dans la colle 15 liquide et servent ainsi à la fixation de l'organe de commande 2 une fois la colle réticulée.

La colle 15 liquide peut alors être injectée dans l'espace délimité par l'élément de commande 2, la surface extérieure courbe de la dalle tactile 3 et l'élément annulaire 17.

Dans le cadre de dalles tactiles 3 à double courbure concave-concave (« cuvette ») où l'organe de commande est disposé au niveau d'un fond de la courbure, l'utilisation d'un élément annulaire 17 peut être omise, puisque la colle 15 liquide restera spontanément dans ledit fond de courbure.

La figure 12 illustre sous forme d'organigramme linéaire les principales étapes d'un autre mode de réalisation de procédé 200.

Dans ce procédé alternatif 200, la première étape 201 est à nouveau la disposition d'un élément annulaire 17, dont le bord inférieur est ajusté à la courbure de la plaque frontale 32 au niveau de la position finale de l'organe de commande 2.

La deuxième étape 203 est alors directement le positionnement de l'organe de commande 2 au niveau d'un bord supérieur de l'élément annulaire 17.

La troisième étape 205 est l'injection de colle 15 liquide dans l'espace interstitiel délimité par la surface supérieure de la dalle tactile 3, l'élément annulaire 17 et la surface inférieure de l'organe de commande 2. De nouveau l'organe de commande 2 peut comprendre des plongeurs destinés à être immergés dans la colle 15 liquide.

La quatrième étape 207 est alors à nouveau une réticulation de la colle 15 initialement liquide, suivie éventuellement d'un retrait de l'élément annulaire 17 s'il n'est pas intégré dans l'interface 1 finalisée.

La couche de colle interstitielle 15, réalisée en particulier à partir de colle liquide réticulée, permet donc de réaliser une interface 1 où aucune lame d'air résiduelle ne persiste entre l'index métallique 6a, 6b et le détecteur capacitif 31 sous-jacent.

L'utilisation de colle 15 initialement liquide assure que la couche durcie épouse parfaitement la surface de la dalle tactile, tout en assurant une surface supérieure de la couche de colle interstitielle 15 parfaitement plane (notamment en prenant une colle liquide de viscosité suffisamment faible).

En sélectionnant une colle 15 transparente, un guide de lumière 7 peut en outre être implémenté, qui permet de récupérer la lumière d'un écran d'affichage 10 situé sous l'organe de commande 2.

On peut ainsi réaliser une interface 1 plaisante esthétiquement et d'usage agréable, intégrée dans l'habitacle du véhicule. La réalisation est en outre plus aisée et donc potentiellement moins coûteuse que dans le cas de l'utilisation d'une pièce usinée (moulage et/ou fraisage et polissage) en lieu et place de la couche de colle interstitielle 15.

En effet une telle pièce nécessiterait un usinage très précis, et par ailleurs les dalles tactiles 3 sont elles-même réalisées avec une certaine tolérance dans leurs dimensions de sorte qu'il resterait presque toujours une fine lame d'air interstitielle entre l'index 6a, 6b et le détecteur capacitif 32.

## Revendications

1. Interface (1), en particulier pour habitacle de véhicule automobile, pour la commande d'au moins une fonction d'un organe de véhicule automobile, comportant :
• au moins un organe de commande (2) comprenant :
∘ un élément mobile de préhension (4),
∘ au moins un index métallique (6a, 6b) porté par l'élément mobile de préhension (4) et mobile avec celui-ci,
∘ un guide (5), l'élément mobile de préhension (4) étant supporté et guidé en déplacement par le guide (5),
ledit organe (2) comportant une surface inférieure plane, et
• une dalle tactile capacitive (3) configurée pour détecter la position de l'index métallique (6a, 6b), l'index métallique (6a, 6b) étant agencé en regard de la dalle tactile capacitive (3),
**caractérisée en ce que** la dalle tactile capacitive (3) présente une surface extérieure courbe selon au moins une direction et **en ce que** l'espace entre l'élément de commande (2) et la surface extérieure courbe de la dalle tactile capacitive (3) est rempli par une couche de colle interstitielle (15) ladite surface inférieure plane de l'organe (2) étant complémentaire de la surface plane de la couche de colle interstitielle (15).

2. Interface selon la revendication 1, **caractérisée en ce que** l'organe de commande (2) est une molette rotative, l'élément mobile de préhension (4) étant une molette circulaire, et le guide (5) comportant un roulement (52) guidant l'élément mobile de préhension (4) en rotation.

3. Interface (1) selon l'une des revendications précédentes, **caractérisée en ce qu'**elle comporte un écran d'affichage (10) configuré pour afficher des informations associées à un contact, un déplacement ou un appui de la partie mobile de préhension (4) ou à un contact ou un appui sur la dalle tactile capacitive (3).

4. Interface (1) selon la revendication précédente, **caractérisée en ce que** l'écran d'affichage (10) est fixé à la dalle tactile capacitive (3), la dalle tactile capacitive (3) étant au moins partiellement transparente.

5. Interface (1) selon la revendication précédente, **caractérisé en ce que** l'organe de commande (2) comporte au moins un guide de lumière (7) présentant un dioptre d'entrée (7a) situé en vis-à-vis de l'écran d'affichage (10) et un dioptre de sortie (7b) situé en direction de l'habitacle du véhicule automobile, et **en ce que** la colle utilisée pour réaliser la couche de colle interstitielle (15) est au moins partiellement transparente dans au moins une portion du spectre visible pour guider de la lumière de l'écran d'affichage (10) vers l'habitacle du véhicule.

6. Interface (1) selon la revendication précédente, **caractérisée en ce que** le guide de lumière (7) comporte une partie centrale cylindrique dont une surface frontale forme un dioptre de sortie (7a), et **en ce qu'**il comporte à son extrémité inférieure une portion plane, s'étendant radialement vers l'extérieur de l'organe de commande (2), formant ainsi un socle (51), et dont la portion radialement extérieure forme un espaceur (14) annulaire, sur lequel le guide (5) de l'élément de préhension mobile (4) prend appui.

7. Interface (1) selon l'une des revendications 4 à 6, **caractérisée en ce qu'**elle comporte au moins un capteur d'appui (11) agencé à l'arrière de l'écran d'affichage (10).

8. Interface (1) selon l'une des revendications 4 à 7, **caractérisée en ce que** l'index métallique (6a, 6b) est relié à une surface extérieure métallique (9a, 9b) de l'élément de préhension mobile (4) par un organe élastique métallique (8a, 8b) configuré pour pousser l'index métallique (6a, 6b) selon une direction sensiblement normale à la surface extérieure de la dalle tactile capacitive (3) vers l'intérieur de l'interface (1).

9. Procédé de fabrication d'interface (1) pour véhicule automobile, l'interface comportant :
∘ au moins un organe de commande (2) comprenant :
▪ un élément mobile de préhension (4),
▪ au moins un index métallique (6a, 6b) porté par l'élément mobile de préhension (4) et mobile avec celui-ci,
▪ un guide (5), l'élément mobile de préhension (4) étant supporté et guidé en déplacement par le guide (5),
ledit organe (2) comportant une surface inférieure plane, et
∘ une dalle tactile capacitive (3) configurée pour détecter la position de l'index métallique (6a, 6b), l'index métallique (6a, 6b) étant agencé en regard de la dalle tactile capacitive (3), présentant une surface extérieure courbe selon au moins une direction,
procédé comportant les étapes suivantes :
• dépôt d'une couche de colle interstitielle (15) réticulable et initialement liquide dans l'espace entre l'organe de commande (2) et la surface extérieure courbe de la dalle tactile capacitive (3),
• fixation de l'organe de commande (2) sur ou au moyen de ladite couche de colle interstitielle (15), ladite surface inférieure plane de l'organe (2) étant complémentaire de la surface plane de la couche de colle interstitielle (15).

10. Procédé de fabrication selon la revendication précédente, **caractérisé en ce qu'**il comporte une étape préalable de disposition d'un élément annulaire (17) au niveau de la position finale de l'organe de commande (2), dont le bord inférieur est ajusté à la courbure de la plaque frontale (32), et **en ce que** l'on injecte de la colle liquide pour former la couche de colle interstitielle (15) dans l'espace délimité par ledit élément annulaire (17), la surface extérieure de la dalle tactile capacitive (3) et l'organe de commande (2).

11. Procédé de fabrication selon la revendication précédente, **caractérisé en ce que** l'élément annulaire (17) forme, après réticulation de la colle formant la couche de colle interstitielle (15), une jupe inférieure de l'organe de commande (2).

12. Procédé de fabrication selon l'une des revendications 9 à 11, **caractérisé en ce que** l'organe de commande (2) comporte sur sa surface inférieure des plongeurs qui plongent dans la couche de colle interstitielle (15), et est disposé sur la dalle tactile capacitive (3) avant une étape de réticulation de la colle de la couche de colle interstitielle (15).

13. Procédé de fabrication selon l'une des revendications 9 à 11, **caractérisé en ce que** l'organe de commande (2) comporte une surface inférieure plane, et **en ce que** l'étape de fixation de l'organe de commande (2) sur la couche de colle interstitielle (15) est effectuée sur la couche de colle interstitielle (15) réticulée par application d'une couche mince de colle

14. Procédé de fabrication selon l'une des revendications précédentes, **caractérisé en ce que** la colle (15) liquide est une colle réticulée par irradiation électromagnétique (*UV*) et **en ce qu'**il comporte une étape d'irradiation électromagnétique (*UV*) de la colle liquide formant la couche de colle interstitielle (15).

## Patentansprüche

1. Schnittstelle (1), insbesondere für einen Kraftfahrzeuginnenraum, zum Bedienen mindestens einer Funktion eines Kraftfahrzeugorgans, beinhaltend:
• mindestens ein Bedienorgan (2), umfassend:
o ein bewegliches Griffelement (4),
o mindestens einen metallischen Index (6a, 6b), der von dem beweglichen Griffelement (4) getragen wird und mit diesem beweglich ist,
o eine Führung (5), wobei das bewegliche Griffelement (4) von der Führung (5) gestützt und bei der Bewegung geführt wird, wobei das Organ (2) eine ebene untere Fläche beinhaltet, und
• eine kapazitive berührungsempfindliche Platte (3), die dazu ausgestaltet ist, die Position des metallischen Index (6a, 6b) zu detektieren, wobei der metallische Index (6a, 6b) gegenüber der kapazitiven berührungsempfindlichen Platte (3) angeordnet ist,
**dadurch gekennzeichnet, dass** die kapazitive berührungsempfindliche Platte (3) eine entlang mindestens einer Richtung gekrümmte Außenfläche aufweist und dass der Raum zwischen dem Bedienelement (2) und der gekrümmten Außenfläche der kapazitiven berührungsempfindlichen Platte (3) mit einer Klebstoffzwischenschicht (15) gefüllt ist, wobei die ebene untere Fläche des Organs (2) komplementär zur ebenen Fläche der Klebstoffzwischenschicht (15) ausgebildet ist.

2. Schnittstelle nach Anspruch 1, **dadurch gekennzeichnet, dass** das Bedienorgan (2) ein Drehrädchen ist, wobei das bewegliche Griffelement (4) ein kreisförmiges Rädchen ist und wobei die Führung (5) ein Wälzlager (52) beinhaltet, welches das bewegliche Griffelement (4) bei seiner Drehung führt.

3. Schnittstelle (1) nach einem der vorhergehenden Ansprüche, **dadurch gekennzeichnet, dass** sie einen Anzeigebildschirm (10) beinhaltet, der dazu ausgestaltet ist, Informationen anzuzeigen, die einer Berührung, einer Bewegung oder einer Betätigung des beweglichen Griffteils (4) oder einer Berührung oder einer Betätigung der kapazitiven berührungsempfindlichen Platte (3) zugeordnet sind.

4. Schnittstelle (1) nach dem vorhergehenden Anspruch, **dadurch gekennzeichnet, dass** der Anzeigebildschirm (10) an der kapazitiven berührungsempfindlichen Platte (3) fixiert ist, wobei die kapazitive berührungsempfindliche Platte (3) mindestens teilweise transparent ist.

5. Schnittstelle (1) nach dem vorhergehenden Anspruch, **dadurch gekennzeichnet, dass** das Bedienorgan (2) mindestens einen Lichtleiter (7) beinhaltet, der einen Eingangsdiopter (7a), der gegenüber dem Anzeigebildschirm (10) gelegen ist, und einen Ausgangsdiopter (7b), der in Richtung des Kraftfahrzeuginnenraums gelegen ist, aufweist, und dass der zum Ausführen der Klebstoffzwischenschicht (15) verwendete Klebstoff in mindestens einem Abschnitt des sichtbaren Spektrums mindestens teilweise transparent ist, um Licht vom Anzeigebildschirm (10) zum Innenraum des Fahrzeugs zu leiten.

6. Schnittstelle (1) nach dem vorhergehenden Anspruch, **dadurch gekennzeichnet, dass** der Lichtleiter (7) einen zylindrischen zentralen Teil beinhaltet, bei dem eine stirnseitige Fläche einen Ausgangsdiopter (7a) bildet, und dass er an seinem unteren Ende einen ebenen Abschnitt beinhaltet, der sich radial nach außerhalb des Bedienorgans (2) erstreckt, so dass er einen Sockel (51) bildet, und bei dem der radial äußere Abschnitt einen ringförmigen Abstandhalter (14) bildet, an dem die Führung (5) des beweglichen Griffelements (4) zur Anlage kommt.

7. Schnittstelle (1) nach einem der Ansprüche 4 bis 6, **dadurch gekennzeichnet, dass** sie mindestens einen Betätigungssensor (11) beinhaltet, der auf der Rückseite des Anzeigebildschirms (10) angeordnet ist.

8. Schnittstelle (1) nach einem der Ansprüche 4 bis 7, **dadurch gekennzeichnet, dass** der metallische Index (6a, 6b) mit einer metallischen Außenfläche (9a, 9b) des beweglichen Griffelements (4) über ein metallisches federndes Organ (8a, 8b) verbunden ist, das dazu ausgestaltet ist, den metallischen Index (6a, 6b) entlang einer Richtung, die im Wesentlichen senkrecht zur Außenfläche der kapazitiven berührungsempfindlichen Platte (3) verläuft, zum Inneren der Schnittstelle (1) hin zu drücken.

9. Verfahren zur Herstellung einer Schnittstelle (1) für ein Kraftfahrzeug, wobei die Schnittstelle beinhaltet:
∘ mindestens ein Bedienorgan (2), umfassend:
▪ ein bewegliches Griffelement (4),
▪ mindestens einen metallischen Index (6a, 6b), der von dem beweglichen Griffelement (4) getragen wird und mit diesem beweglich ist,
▪ eine Führung (5), wobei das bewegliche Griffelement (4) von der Führung (5) gestützt und bei der Bewegung geführt wird,
wobei das Organ (2) eine ebene untere Fläche beinhaltet,
und
o eine kapazitive berührungsempfindliche Platte (3), die dazu ausgestaltet ist, die Position des metallischen Index (6a, 6b) zu detektieren, wobei der metallische Index (6a, 6b) gegenüber der kapazitiven berührungsempfindlichen Platte (3) angeordnet ist, die eine entlang mindestens einer Richtung gekrümmte Außenfläche aufweist,
wobei das Verfahren die folgenden Schritte beinhaltet:
• Aufbringen einer vernetzbaren und anfänglich flüssigen Klebstoffzwischenschicht (15) in dem Raum zwischen dem Bedienorgan (2) und der gekrümmten Außenfläche der kapazitiven berührungsempfindlichen Platte (3),
• Fixieren des Bedienorgans (2) auf oder mittels der Klebstoffzwischenschicht (15), wobei die ebene untere Fläche des Organs (2) komplementär zur ebenen Fläche der Klebstoffzwischenschicht (15) ausgebildet ist.

10. Herstellungsverfahren nach dem vorhergehenden Anspruch, **dadurch gekennzeichnet, dass** es einen vorherigen Schritt des Anordnens eines ringförmigen Elements (17) auf Höhe der endgültigen Position des Bedienorgans (2) beinhaltet, dessen unterer Rand an die Krümmung der stirnseitigen Scheibe (32) angepasst ist, und dass flüssiger Klebstoff eingespritzt wird, um die Klebstoffzwischenschicht (15) in dem Raum zu bilden, der durch das ringförmige Element (17), die Außenfläche der kapazitiven berührungsempfindlichen Platte (3) und das Bedienorgan (2) begrenzt wird.

11. Herstellungsverfahren nach dem vorhergehenden Anspruch, **dadurch gekennzeichnet, dass** das ringförmige Element (17) nach Vernetzung des die Klebstoffzwischenschicht (15) bildenden Klebstoffs eine untere Einfassung des Bedienorgans (2) bildet.

12. Herstellungsverfahren nach einem der Ansprüche 9 bis 11, **dadurch gekennzeichnet, dass** das Bedienorgan (2) auf seiner unteren Fläche Tauchelemente beinhaltet, die in die Klebstoffzwischenschicht (15) tauchen, und auf der kapazitiven berührungsempfindlichen Platte (3) vor einem Schritt des Vernetzens des Klebstoffs der Klebstoffzwischenschicht (15) angeordnet wird.

13. Herstellungsverfahren nach einem der Ansprüche 9 bis 11, **dadurch gekennzeichnet, dass** das Bedienorgan (2) eine ebene untere Fläche beinhaltet und dass der Schritt des Fixierens des Bedienorgans (2) auf der Klebstoffzwischenschicht (15) auf der vernetzten Klebstoffzwischenschicht (15) durch Applizieren einer dünnen Klebstoffschicht durchgeführt wird.

14. Herstellungsverfahren nach einem der vorhergehenden Ansprüche, **dadurch gekennzeichnet, dass** der flüssige Klebstoff (15) ein durch elektromagnetische Bestrahlung (*UV*) vernetzter Klebstoff ist, und dass es einen Schritt des elektromagnetischen Bestrahlens (*UV*) des die Klebstoffzwischenschicht (15) bildenden flüssigen Klebstoffs beinhaltet.

## Claims

1. Interface (1), in particular for a motor vehicle interior, for controlling at least one function of a motor vehicle member, comprising:
• at least one control member (2) comprising:
o a movable gripping element (4),
o at least one metal index (6a, 6b) borne by the movable gripping element (4) and movable therewith,
o a guide (5), the movable gripping element (4) being supported and guided in displacement by the guide (5),
said member (2) comprising a flat bottom surface, and
• a capacitive touch pad (3) configured to detect the position of the metal index (6a, 6b), the metal index (6a, 6b) being arranged opposite the capacitive touch pad (3),
**characterized in that** the capacitive touch pad (3) has an outer surface curved in at least one direction and **in that** the space between the control element (2) and the curved outer surface of the capacitive touch pad (3) is filled by an interstitial glue layer (15), said flat bottom surface of the member (2) complementing the flat surface of the interstitial glue layer (15).

2. Interface according to Claim 1, **characterized in that** the control member (2) is a rotary thumb wheel, the movable gripping element (4) being a circular thumb wheel, and the guide (5) comprising a rolling bearing (52) guiding the movable gripping element (4) in rotation.

3. Interface (1) according to one of the preceding claims, **characterized in that** it comprises a display screen (10) configured to display information associated with a contact, a displacement or a press of the movable gripping part (4) or with a contact or a press on the capacitive touch pad (3).

4. Interface (1) according to the preceding claim, **characterized in that** the display screen (10) is fixed to the capacitive touch pad (3), the capacitive touch pad (3) being at least partially transparent.

5. Interface (1) according to the preceding claim, **characterized in that** the control member (2) comprises at least one light guide (7) having an input dioptre (7a) situated facing the display screen (10) and an output dioptre (7b) situated facing the interior of the motor vehicle, and **in that** the glue used to produce the interstitial glue layer (15) is at least partially transparent in at least a portion of the visible spectrum to guide the light from the display screen (10) to the interior of the vehicle.

6. Interface (1) according to the preceding claim, **characterized in that** the light guide (7) comprises a cylindrical central part, a front-end surface of which forms an output dioptre (7a), and **in that** it comprises, at its bottom end, a flat portion, extending radially outward from the control member (2), thus forming a base (51), and the radially outer portion of which forms an annular spacer (14), on which the guide (5) of the movable gripping element (4) bears.

7. Interface (1) according to one of Claims 4 to 6, **characterized in that** it comprises at least one bearing sensor (11) arranged behind the display screen (10).

8. Interface (1) according to one of Claims 4 to 7, **characterized in that** the metal index (6a, 6b) is linked to a metal outer surface (9a, 9b) of the movable gripping element (4) by a metal elastic member (8a, 8b) configured to push the metal index (6a, 6b) in a direction substantially normal to the outer surface of the capacitive touch pad (3) towards the interior of the interface (1).

9. Method for manufacturing an interface (1) for a motor vehicle, the interface comprising:
∘ at least one control member (2) comprising:
• a movable gripping element (4),
• at least one metal index (6a, 6b) borne by the movable gripping element (4) and movable therewith,
• a guide (5), the movable gripping element (4) being supported and guided in displacement by the guide (5),
said member (2) comprising a flat bottom surface, and
o a capacitive touch pad (3) configured to detect the position of the metal index (6a, 6b), the metal index (6a, 6b) being arranged facing the capacitive touch pad (3), having an outer surface curved in at least one direction,
the method comprising the following steps:
• deposition of a cross-linkable and initially liquid interstitial glue layer (15) in the space between the control member (2) and the curved outer surface of the capacitive touch pad (3),
• fixing of the control member (2) on or by means of said interstitial glue layer (15), said flat bottom surface of the member (2) complementing the flat surface of the interstitial glue layer (15) .

10. Manufacturing method according to the preceding claim, **characterized in that** it comprises a preliminary step of arrangement of an annular element (17) at the final position of the control member (2), the bottom edge of which is fitted to the curvature of the front-end plate (32), and **in that** liquid glue is injected to form the interstitial glue layer (15) in the space delimited by said annular element (17), the outer surface of the capacitive touch pad (3) and the control member (2) .

11. Manufacturing method according to the preceding claim, **characterized in that** the annular element (17) forms, after cross-linking of the glue forming the interstitial glue layer (15), a bottom skirt of the control member (2).

12. Manufacturing method according to one of Claims 9 to 11, **characterized in that** the control member (2) comprises, on its bottom surface, plungers which penetrate into the interstitial glue layer (15), and is arranged on the capacitive touch pad (3) before a step of cross-linking of the glue of the interstitial glue layer (15).

13. Manufacturing method according to one of Claims 9 to 11, **characterized in that** the control member (2) comprises a flat bottom surface, and **in that** the step of fixing of the control member (2) on the interstitial glue layer (15) is performed on the cross-linked interstitial glue layer (15) by application of a thin layer of glue.

14. Manufacturing method according to one of the preceding claims, **characterized in that** the liquid glue (15) is a glue cross-linked by electromagnetic irradiation (*UV*) and **in that** it comprises a step of electromagnetic irradiation (*UV*) of the liquid glue forming the interstitial glue layer (15).
